# EUROPÄISCHE PATENTSCHRIFT

(11) **EP 2 517 239 B1**
(45) Veröffentlichungstag und Bekanntmachung des Hinweises auf die Patenterteilung: **02.10.2013**
(21) Anmeldenummer: 10796036.1
(22) Anmeldetag: 21.12.2010
(51) Int. Cl.: H01L 23/00, H01L 23/48, H01L 23/482

(54) **VERFAHREN ZUR HERSTELLUNG EINES ELEKTRONISCHEN BAUTEILS UND NACH DIESEM VERFAHREN HERGESTELLTES ELEKTRONISCHES BAUTEIL**
METHOD FOR FABRICATING AN ELECTRONIC DEVICE AND ELECTRONIC DEVICE FABRICATED BY THIS METHOD
PROCÉDÉ DE FABRICATION D'UN COMPOSANT ÉLECTRONIQUE ET COMPOSANT ÉLECTRONIQUE FABRIQUÉ SELON CE PROCÉDÉ

(30) Priorität: 23.12.2009 DE 102009059303
(43) Veröffentlichungstag der Anmeldung: 31.10.2012
(73) Patentinhaber: United Monolithic Semiconductors GmbH, 89081 Ulm (DE)
(72) Erfinder: JONSSON, Günter, 89079 Ulm (DE); STIEGLAUER, Hermann, 89134 Blaustein (DE)
(74) Vertreter: Baur & Weber Patentanwälte
(86) Internationale Anmeldenummer: PCT/EP2010/070357
(87) Internationale Veröffentlichungsnummer: WO 2011/076782

(56) Entgegenhaltungen:
- JP-A- 2004 088 062
- JP-A- 2005 033 116
- US-A- 5 698 897
- US-A1- 2002 030 267

## Beschreibung

Die Erfindung betrifft ein Verfahren zur Herstellung eines elektronischen Bauteils und ein nach einem solchen Verfahren hergestelltes elektronisches Bauteil.

Bei elektronischen Bauteilen mit wenigstens einem Halbleiterbauelement auf einem Halbleitersubstrat muss in dem Halbleiterbauelement im Betrieb anfallende Verlustwärme abgeführt werden. Dies ist insbesondere für Hochfrequenz-Leistungsbauteile von Bedeutung. Das wenigstens eine Bauelement bzw. typischerweise ein eine Mehrzahl von Bauelementen enthaltender monolithisch integrierter Schaltkreis ist auf der Vorderseite des Substrats ausgebildet und die Verlustwärme wird durch das Substrat über dessen Rückseite an eine Wärmesenke abgeführt und beispielsweise über eine Oberfläche eines Gehäuses des Bauteils abgegeben. Die Substrate weisen häufig von der Rückseite zur Vorderseite des Substrats durchgehende Öffnungen, sogenannte via holes auf, welche als elektrisch leitende Durchkontaktierungen von einer flächigen Rückseiterimetallisierung zu Leiterflächen auf der Vorderseite des Substrats dienen.

Typischerweise wird auf der Rückseite des Substrats einschließlich der via holes eine Leitschicht aus Gold(Au) abgeschieden, wobei zur festen Verbindung der Au-Leitschicht mit der Oberfläche des Halbleiter-Substrats üblicherweise eine Haftvermittlerschicht, welche z. B. für polierte Substratoberflächen Ge, für nur grob geschliffene Substratoberflächen Ti, Ta, W, Pd oder Cr enthalten kann, aufgebracht und auf welcher die Au-Leitschicht, vorzugsweise nisch, abgeschieden wird. Ti dient insbesondere bei nur grob geschliffenen Oberflächen der Substrat-Rückseite als Haftvermittler mit guter mechanischer Verankerung zum Halbleitermaterial. Wegen besserer Eigenschaften hinsichtlich der Bruchfestigkeit und der Photolithografie bei der Erzeugung der via holes sind fein geschliffene Rückseiten-Oberflächen bevorzugt, welche aber keine gute mechanische Verankerung zeigen. Für die bevorzugten fein geschliffenen Oberflächen der Rückseite von GaAs-Substraten wird daher in der Regel Ge als Haftvermittlerschicht auf der Substrat-Rückseite und in den via holes abgeschieden. Auf der Haftvermittlerschicht wird Au abgeschieden, wobei in der Regel eine erste dünne Gold-Schicht aufgesputtert und auf dieser galvanisch eine dickere Au-Schicht als Leitschicht mit hoher thermischer und elektrischer Leitfähigkeit erzeugt wird. Die dem Substrat abgewandte Oberfläche der Rückseitenmetallisierung wird mit einer Wärmesenke verlötet, wobei als Lot typischerweise eine eutektische AuSn₄-Legierung, insbesondere in Form eines dünnen Preform-Films eingesetzt wird. Die dem Substrat bzw. dem Preform-Film zuweisende Oberfläche der Wärmesenke weist typischerweise gleichfalls eine Au-Oberfläche auf. Die Lötverbindung zwischen Substrat und Wärmesenke ist insbesondere auf Seiten des Substrats anfällig für das Entstehen von die Wärmeübertragung beeinträchtigenden Hohlräumen. Die Parameter des Lötprozesses sind mit nach Zeit und Temperatur engen Toleranzen einzuhalten, um Fehler in der Lötverbindung gering zu halten.

Die nach den bekannten Verfahren hergestellten Bauteile auf GaAs-Substraten zeigen immer wieder Degradationen und Ausfälle in der Funktion vor allem von mit höherer Leistung bei hohen Frequenzen betriebenen Bauelemente.

In der JP 2004-088062 A ist ein Halbleiterbauelement gezeigt, bei dem Durchkontaktierungen zwischen einer Substratrückseite und einer über Passivierungsmaterial angeordneten Leiterebene gezeigt sind. Die Durchkontaktierungen weisen eine erste dünne Schicht auf, welche als Startschicht für eine nachfolgende galvanische Goldschicht aufgesputtert wird.

In der US 5 689 897 wird vorgeschagen, nach einer direkt auf die Rückseite eines Hableitersubstrats abgeschiedenen Schicht eine Schicht beispielsweise aus Wolfram aufzubringen. Es kann aber auch ein Schichtenstapel abwechselnd aus Gold- und Wolframschichten vorgesehen sein, wobei zwischen der Gold- und der Wolframschicht Titan eingefügt sein kann.

Im Konferenzbeitrag "How to Process the Backside of GaAs Wafers" von Varmazis et al. in Semiconductor International, 1. Dez. 2001 sind Probleme und Verfahren der Rückseitenmetallisierung von Halbleitersubstraten mit Durchgangskontaktierungen diskutiert. Um ein zu mechanischen Spannungen führendes Verfüllen der Durchgangskontaktierungen mit dem geschmolzenen AuSn-Lot zu verhindern, wird vorgeschlagen, die Oberfläche der Au-Schicht der Rückseitenmetallisierung mit einer zusätzlichen Schicht aus Ti, Ni oder Cr zu überdecken und diese zusätzliche Schicht mittels einer Photomaske und einem Ätzprozess auf der ebenen Fläche der Rückseitenmetallisierung außerhalb der Durchgangskontaktierungen wieder zu entfernen, um die Au-Oberfläche der Au-Schicht wieder freizulegen. Nach der Entfernung der Photomaske ist in den Durchgangslöchern die Oberfläche durch die zusätzliche Schicht gegeben, welche oxidiert und schlecht mit dem AuSn-Lot benetzbar ist.

Der vorliegenden Erfindung liegt die Aufgabe zugrunde, ein Verfahren zur Herstellung eines elektronischen Bauteils, insbesondere auf einem GaAs-Substrat mit einer überwiegend durch eine Au-Schicht gebildeten Rückseitenmetallisierung, sowie ein nach diesem Verfahren hergestelltes Bauteil anzugeben.

Erfindungsgemäße Lösungen sind in den unabhängigen Ansprüchen beschrieben. Die abhängigen Ansprüche enthalten vorteilhafte Ausgestaltungen und Weiterbildungen der Erfindung.

Der Erfindung liegt die Erkenntnis zugrunde, dass an den herkömmlichen Bauteilen auftretende Defekte in nicht unerheblichem Umfang mit dem Haftmetall, welches unmittelbar auf das Halbleitermaterial der Substrat-Rückseite abgeschieden wird, zusammenhängen. Insbesondere führt Ge als Haftmetallschicht aufgrund guter Diffusion in das Substratmaterial zwar zu einer sehr guten Haftung auf Substratmaterial mit polierter bzw. fein geschliffener Oberfläche, andererseits bewirkt die starke Diffusion von Ge auch Störungen an der Grenzfläche zu der nachfolgenden Schicht der Rückseitenmetallisierung und kann sogar an der dem Substrat abgewandten Oberfläche der Rückseitenmetallisierung zu schlechter Benetzung mit einem zur Verbindung mit einer Wärmesenke eingesetztem Lot führen. Diese Effekte können insbesondere zur Verschlechterung der Abführung von Verlustwärme eines auf der Substrat-Vorderseite angeordneten Bauelements führen. Ferner zeigt sich, dass Ge, insbesondere an den Rändern von Durchgangslöchern bei der Vorderseite des Substrats durch das Substratmaterial zu aktiven Bauelementen wandern und eine Degradation der Bauelementeigenschaften verursachen kann.

Die in der Beschreibung und den Ansprüchen explizit genannten chemischen Elemente Gallium Ga, Arsen As, Titan Ti, Gold Au, Germanium Ge, Stickstoff N, Tantal Ta, Wolfram W, Palladium Pd, Chrom Cr und weitere sind jeweils durch ihre chemisch gebräuchlichen Abkürzungen angeführt.

Die erfindungsgemäße Verwendung von Au als Material der unmittelbar auf das Halbleitermetall der Substrat-Rückseite abgeschiedenen Haftschicht beseitigt überraschend die genannten Probleme bei zuverlässiger Haftung an dem Substrat. Vorzugsweise wird die Substrat-Rückseite vor Abscheiden der Au-Haftschicht auf eine mittlere Rautiefe von weniger als 4 nm poliert. Aus der ersten Au-Schicht diffundiert Au in das Substratmaterial, was für die gute Haftung auf einer glatten Substratoberfläche von besonderem Vorteil ist. Die Dicke der ersten Au-Schicht beträgt vorteilhafterweise wenigstens 25 nm, insbesondere wenigstens 35 nm. Die Diffusion ist aber deutlich schwächer als die von Ge, so dass keine Degradation von Bauelementen auftritt. Zugleich diffundiert auch Ga aus dem Halbleitermaterial in die erste Au-Schicht.

Um die gegenseitige Diffusion von Au in das Halbleitermaterial und Ga in die erste Au-Schicht zu begrenzen, ist vorteilhafterweise die Dicke der ersten Au-Schicht auf höchstens 100 nm, insbesondere höchstens 75 nm begrenzt. Eine bevorzugte Schichtdicke der ersten Au-Schicht liegt bei ca. 50 nm. In Durchgangslöchern durch das Substrat die Rückseitenmetallisierung ist in an sich gebräuchlicher Weise gleichfalls abgeschieden, wobei vorzugsweise die Schichtdicke zumindest der ersten Au-Schicht an den Wänden der Durchgangslöcher geringer ist als auf der Rückseite des Substrats.

Erfindungsgemäß ist zwischen der ersten Au-Schicht und der Au-Leitschicht, vorzugsweise unmittelbar auf der ersten Au-Schicht, eine Diffusionsbarrierenschicht abgeschieden, welche zum einen durch Begrenzung der Schichtdicke der ersten Au-Schicht das Au-Angebot für die Eindiffusion in das Substratmaterial begrenzt und zum anderen insbesondere das Fortschreiten der Diffusion des aus dem Substratmaterial durch die erste Au-Schicht wandernden Ga behindert. Das Material der Diffusionsbarrierenschicht ist daher so gewählt, dass der Diffusionskoeffizient von Ga in dem Material der Diffusionsbarrierenschicht geringer ist als in der ersten Au-Schicht. Die Diffusionsbarrierenschicht enthält vorteilhafterweise Ti als wesentlichen Bestandteil, welchem zum weiteren Herabsetzen der Diffusion von Ga vorteilhafterweise N beigemischt sein kann.

Die Diffusionsbarrierenschicht wird vorteilhafterweise auch an Seitenflanken von Durchkontaktierungen durch das Substrat abgeschieden und wirkt vorteilhafterweise im Bereich nahe der Vorderseite als Barriere gegen die Diffusion von Atomen der Rückseitenmetallisierung und/oder Lotmaterial in die aktiven Halbleiterbereiche.

Vorteilhafterweise ist zwischen der Diffusionsbarrierenschicht und der Au-Leitschicht, insbesondere unmittelbar auf der Diffusionsbarrierenschicht eine zweite Au-Schicht als Startmetall für die galvanische Abscheidung der Au-Leitschicht abgeschieden, insbesondere aufgesputtert. Die Eigenschaften gesputteter Au-Schichten unterschieden sich z. B. hinsichtlich der Diffusionskoeffizienten anderer Metalle an diesen Schichten von galvanisch abgeschiedenen Au-Schichten. Die Diffusionsbarrierenschicht kann in bevorzugter Ausführung in Richtung senkrecht zur Schichtebene mit wechselnder Zusammensetzung aufgebaut sein, wobei vorteilhafterweise in einem Bereich an der Grenzfläche zu der ersten Au-Schicht und/oder in einem Bereich an der Grenzfläche zu der zweiten Au-Schicht die Diffusionsbarrierenschicht aus Ti besteht und in einem mittleren Schichtbereich als Material mit für Ga weiter stark verringertem Diffusionskoeffizienten TiN vorliegt.

Auf der dem Substrat abgewandten Seite der Au-Leitschicht können weitere Schichten als Teil der Rückseitenmetallisierung abgeschieden sein.

Die Erfindung ist nachfolgend anhand eines bevorzugten Ausführungsbeispiels noch eingehend veranschaulicht. Dabei zeigt:
- Fig. 1: einen Schnitt durch ein Bauteil,
- Fig. 2: einen Schichtaufbau einer Rückseitenmetallisierung.

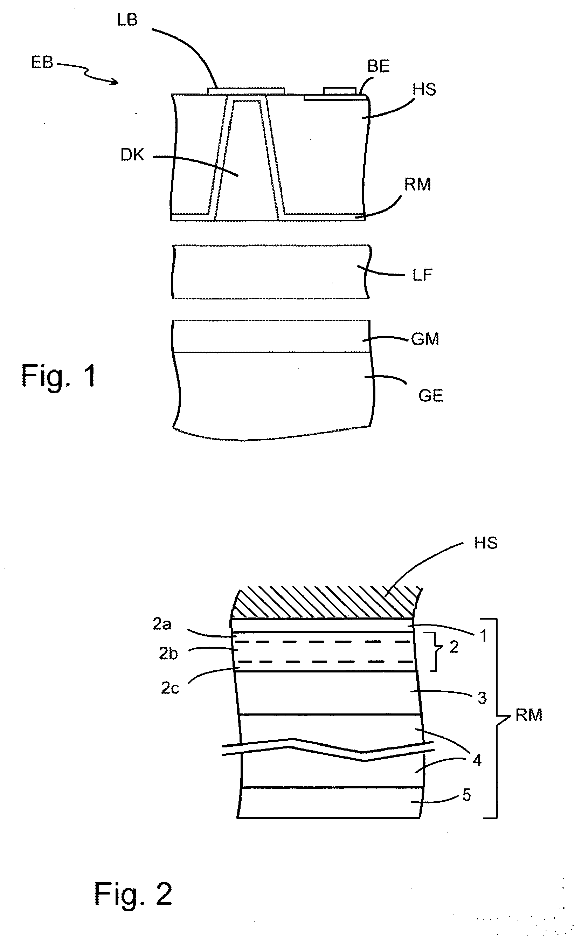

Fig. 1 zeigt eine Zusammenbaudarstellung einer Halbleiterbaugruppe mit einer Gehäusefläche über eine Lötverbindung. Ein Halbleitersubstrat HS trägt auf seiner in Fig. 1 nach oben weisenden Vorderseite ein oder typischerweise mehrere Halbleiterbauelemente BE sowie metallische Leiterbahnen LB. Die der Vorderseite entgegen gesetzte Rückseite des Halbleitersubstrats HS ist mit einer Rückseitenmetallisierung RM versehen. Durch das Substrat hindurch sind Durchgangslöcher DK ausgespart, deren Wände gleichfalls mit der Rückseitenmetallisierung RM beschichtet sind und Durchkontaktierungen zu Leiterbahnen LB auf der Vorderseite des Substrats bilden können.

Die elektronische Baugruppe EB ist im skizzierten typischen Beispiel zur gut wärmeleitenden Verbindung mit einer Wärmesenke, beispielsweise einem Gehäuse GE vorgesehen, wofür an dem Gehäuse eine Metallschicht GM vorgesehen ist und die Rückseitenmetallisierung RM der elektronischen Baugruppe mittels eines, beispielsweise als dünner Film vorliegenden Lotes mit der Metallschicht GM verlötbar ist.

Die Rückseitenmetallisierung erfüllt dabei sowohl eine Funktion als elektrischer Leiter entlang der Substratrückseite zu Leiterbahnen LB durch die Durchgangslöcher DK als auch eine wärmeleitende Funktion zur Ableitung von in Bauelementen BE beim Betrieb anfallender Verlustleistung zu dem Gehäuse GE als Wärmesenke. Für die elektrische Funktion ist ein geringer Schichtwiderstand, für die wärmeleitende Funktion neben einer guten Wärmeleitfähigkeit insbesondere eine gute Verbindung der verschiedenen Schichten zwischen Substrat und Gehäuse GE, insbesondere zwischen Substrat und Rückseitenmetallisierung sowie Rückseitenmetallisierung und Lotschicht von Bedeutung.

Bei Verwendung von Germanium als unmittelbar mit dem GaAs-Halbleitermaterial der Substrat-Rückseite in Kontakt stehender Haftschicht ist in der Regel ein gut wärmeleitender Kontakt zwischen Substrat und Rückseitenmetallisierung gewährleistet. Es zeigt sich aber, dass Ge Ursache für Störungen der Wärmeleitung zwischen Rückseitenmetallisierung und Lotschicht sein kann sowie Degradationen der Eigenschaften der Bauelemente auf der Vorderseite des Substrats verursachen kann.

Fig. 2 zeigt einen erfindungsgemäßen Aufbau einer aus mehreren Schichten zusammen gesetzten Rückseitenmetallisierung. Die Substrat-Rückseite ist vorteilhafterweise auf eine geringe Rauigkeit mit einer mittleren Rautiefe von weniger als 4 mm poliert. Auf die Rückseite des Halbleitersubstrats HS ist als eine Haftschicht eine erste Au-Schicht 1 aufgesputtert. Auf die erste Au-Schicht 1 ist eine Diffusionsbarrierenschicht 2 und auf diese eine zweite Au-Schicht 3 aufgesputtert. Die Diffusionsbarrierenschicht 2 besteht in einem Bereich 2a an der Grenzfläche zu der ersten Au-Schicht 1 sowie in einem Bereich 2c an der Grenzfläche zur zweiten Au-Schicht 2 vorzugsweise aus Ti. In einem mittleren Schichtbereich 2b der Diffusionsbarrierenschicht besteht diese vorteilhafterweise aus TiN.

Der Diffusionskoeffizient von Au in GaAs ist geringer als der von Ge, aber ausreichend hoch, um eine gute flächig im wesentlichen durchgehende Verankerung der ersten Au-Schicht auf der polierten Oberfläche der Substrat-Rückseite zu gewährleisten. Hierdurch ist ein besonders guter Wärmeübergang vom Substrat in die Haftschicht gewährleistet. Eine für Ti-Haftschichten typische mechanische Haftung über geometrisches Ineinandergreifen von Substrat-Rückseite und Haftschicht ist nicht erforderlich. Durch den mehrschichtigen Aufbau der Diffusionsbarrierenschicht 2 wird zum einen eine zuverlässig feste Verbindung zwischen Ti in den Bereichen 2a, 2c und den angrenzenden Au-Sputterschichten gewährleistet, zum anderen bildet TiN als mittlerer Schichtbereich eine besonders effektive Diffusionsbarriere für Ga aus dem Halbleitersubstrat HS. Die zweite Au-Schicht 3 dient als Startmetall für die galvanische Abscheidung einer Au-Leitschicht 4, deren Dicke wenigstens 50 % der Gesamtdicke der Rückseitenmetallisierung ausmacht. Auf die galvanisch abgeschiedene dicke Au-Leitschicht 4 kann eine abschließend Schicht 5 vorgesehen sein, die dem Lot zugewandte Oberfläche der Rückseitenmetallisierung bildet, welche auch als eine Folge von mehreren Teilschichten aufgebaut sein kann und insbesondere wiederum eine gesputterte Au-Schicht enthalten kann.

Die Diffusionsbarrierenschicht 2 begrenzt vorteilhafterweise den Vorrat an Au, welcher in der ersten Au-Schicht für eine Diffusion in das Halbleitersubstrat HS und zur Aufnahme von Ga aus dem Halbleitersubstrat zur Verfügung steht, so dass der Diffusionsprozess zwischen der ersten Au-Schicht und dem Halbleitersubstrat auf das zur Verankerung notwendige Ausmaß beschränkt werden kann. Der Diffusionskoeffizient von Ti in GaAs ist besonders klein, so dass die Diffusion von Ti aus dem Bereich 2a durch die erste Au-Schicht 1 in das Halbleitersubstrat HS keine Rolle spielt. Die Diffusionsbarrierenschicht, insbesondere der mittlere Bereich behindert effektiv die Wanderung von Ga in Richtung der Au-Leitschicht 4, wo Ga zu einer Erhöhung des Schichtwiderstands führen könnte, sowie eine Diffusion von Ga bis zu der dem Substrat abgewandten Oberfläche der gesamten Rückseitenmetallisierung, wo Störungen der Benetzung mit Lot beim Lötvorgang auftreten könnten.

Die Dicke der ersten Au-Schicht 1 beträgt vorteilhafterweise auf der Rückseite des Halbleitersubstrats wenigstens 25 nm, insbesondere wenigstens 35 nm und höchstens 100 nm, insbesondere höchstens 75 nm. Bevorzugt ist eine Dicke der ersten Au-Schicht 1 von ca. 50 nm.

Die Dicke der Diffusionsbarrierenschicht ist vorteilhafterweise größer als die Dicke der ersten Au-Schicht und liegt vorteilhafterweise zwischen 100 nm und 400 nm, insbesondere zwischen 150 nm und 300 nm. Bei mehrschichtigem Aufbau der Barrierenschicht liegt die Dicke der Bereiche 2a, 2c vorteilhafterweise zwischen 5 nm und 30 nm. Die Schichtdicke der zweiten Au-Schicht 3 als Startmetall für die galvanische Abscheidung der Au-Leitschicht 4 liegt vorteilhafterweise in einem Bereich von 50 nm bis 500 nm. Die Schichtdicke der Au-Leitschicht 4 beträgt ein Vielfaches der vorgenannten Schichtdicken und liegt typischerweise in einem Bereich zwischen 2000 nm und 5000 nm. Die Schichtdicke der letzten Schicht oder Schichtenfolge 5 liegt vorteilhafterweise zwischen 200 nm und 400 nm.

Die Schichtenfolge der Schichten 1 bis 5 der Rückseitenmetallisierung liegt vorteilhafterweise auch als Metallisierung der Seitenwände der Durchgangslöcher DK vor, wo vorteilhafterweise zumindest die Schichtdicke der ersten Au-Schicht 1 geringer ist als an der Rückseite des Substrats und insbesondere an den Seitenwänden der Durchgangslöcher im Bereich der Vorderseite des Substrats nicht mehr als 50 % der Schichtdicke dieser ersten Au-Schicht 1 auf der ebenen Rückseite des Substrats beträgt. Hierdurch wird das Angebot an Au zur Diffusion in das Halbleitermaterial in der eventuell kritischen Nähe von Bauelementen BE weiter herabgesetzt und somit die Gefahr von Degradationen der Bauelemente durch Eindiffundieren von Gold weiter verringert. Die Anforderungen an eine Verankerung der Haftschicht in dem Halbleitersubstrat sind in diesem Bereich nicht so streng wie auf der Rückseite des Halbleitersubstrats, da diese Bereiche in der Nähe der Vorderseite des Substrats für die Ableitung von Verlustwärme eine untergeordnete Rolle spielen. Die Diffusionsbarrierenschicht vermindert oder verhindert in den Durchgangslöchern insbesondere in der Nähe der Substrat-Vorderseite die Diffusion von Atomen aus den danach abgeschiedenen Schichten der Rückseitenmetallisierung oder aus dem eventuell in die Durchgangslöcher gelangenden Lotmaterial in Richtung der aktiven Bauelemente.

Für die Diffusionsbarrierenschicht ist Ti als wesentlicher Bestandteil bevorzugt, es können aber allgemeiner auch andere Materialien mit den Eigenschaften guter Verbindung zu den benachbarten Au-Schichten und niedrigem Diffusionskoeffizienten für Ga in diesen Diffusionsbarriereschichten sowie niedrigem Diffusionskoeffizienten des Materials der Diffusionsbarriereschichten in GaAs zum Einsatz kommen. Insbesondere geeignet sind alle Refraktärmetalle, worunter hierbei die teilweise auch als Refraktärmetalle im weiteren Sinne bezeichneten hochschmelzenden unedlen Metalle der 4., 5. und 6. Nebengruppe des Periodensystems sowie Rhenium, also Ti, V, Cr, Zr, Nb, Mo, Hf, Ta, W, Re verstanden sein sollen, sowie deren Verbindungen mit N.

Die vorstehend und die in den Ansprüchen angegebenen sowie die den Abbildungen entnehmbaren Merkmale sind sowohl einzeln als auch in verschiedener Kombination vorteilhaft realisierbar. Die Erfindung ist nicht auf die beschriebenen Ausführungsbeispiele beschränkt, sondern im Rahmen fachmännischen Könnens in mancherlei Weise abwandelbar.

## Patentansprüche

1. Verfahren zur Herstellung eines elektronischen Bauteils (EB) mit wenigstens einem Halbleiter-Bauelement (BE) auf der Vorderseite eines GaAs-Substrats (HS), wobei die dem Bauelement abgewandte Rückseite des Substrats mit einer Rückseitenmetallisierung (RM) versehen wird, bei welcher auf die Oberfläche des Substratmaterials eine Haftschicht aufgebracht und danach eine Au-Leitschicht (4) mit wenigstens 50 % der Gesamtdicke der Rückseitenmetallisierung abgeschieden wird, wobei als Haftschicht eine erste Au-Schicht (1) abgeschieden wird und zwischen der ersten Au-Schicht (1) und der Au-Leitschicht (4) eine Diffusionsbarrierenschicht (2) abgeschieden wird, **dadurch gekennzeichnet, dass** die Diffusionsbarrierenschicht (2) mit größerer Schichtdicke abgeschieden wird als die erste Au-Schicht (1).

2. Verfahren nach Anspruch 1, **dadurch gekennzeichnet, dass** die erste Au-Schicht (1) mit einer Schichtdicke von wenigstens 25 nm, insbesondere wenigstens 35 nm und höchstens 100 nm, insbesondere höchstens 75 nm abgeschieden wird.

3. Verfahren nach Anspruch 1 oder 2, **dadurch gekennzeichnet, dass** vor Abschieden der ersten Au-Schicht (1) die Rückseite des Substrats (HS) auf weniger als 4 nm mittlerer Rautiefe poliert wird.

4. Verfahren nach Anspruch 1 bis 3, **dadurch gekennzeichnet, dass** zwischen der Diffusionsbarrierenschicht (2) und der Au-Leitschicht (4) eine zweite Au-Schicht (3) abgeschieden wird.

5. Verfahren nach Anspruch 4, **dadurch gekennzeichnet, dass** die Diffusionsbarrierenschicht (2) zumindest im Bereich (2a) der Grenzfläche zu der ersten Au-Schicht und/oder im Bereich (2c) der Grenzfläche zu der zweiten Au-Schicht aus wenigstens einem Refraktärmetall, insbesondere aus Ti, besteht.

6. Verfahren nach einem der Ansprüche 1 bis 5, **dadurch gekennzeichnet, dass** die Diffusionsbarrierenschicht zumindest in einem mittleren Schichtbereich (2c) N enthält.

7. Verfahren nach einem der Ansprüche 1 bis 6, **dadurch gekennzeichnet, dass** die erste Au-Schicht (1) und/oder die Diffusionsbarrierenschicht (2) und/oder die zweite Au-Schicht (3) aufgesputtert werden.

8. Verfahren nach einem der Ansprüche 1 bis 7, **dadurch gekennzeichnet, dass** die Au-Leitschicht (4) galvanisch abgeschieden wird.

9. Verfahren nach einem der Ansprüche 1 bis 8, **dadurch gekennzeichnet, dass** vor Abscheiden der Rückseitenmetallisierung (RM) wenigstens ein Durchgangsloch (DK) durch das Substrat (HS) erzeugt wird und dass die Rückseitenmetallisierung auch in dem Durchgangsloch abgeschieden wird.

10. Verfahren nach Anspruch 9, **dadurch gekennzeichnet, dass** zumindest die erste Au-Schicht (1) in dem Durchgangsloch (DK) mit geringerer Schichtdikke als auf der Substrat-Rückseite abgeschieden wird.

11. Elektronisches Bauteil (EB) mit einem GaAs-Halbleiter-Substrat (HS), welches auf seiner Substrat-Vorderseite wenigstens ein Halbleiter-Bauelement (BE) und auf der Substrat-Rückseite eine Rückseitenmetallisierung aufweist, wobei die Rückseitenmetallisierung (RM) wenigstens eine mit dem Halbleitermaterial des Substrats in Kontakt stehende Haftschicht (1) und eine Au-Leitschicht, welche wenigstens 50 % der Schichtdicke der Rückseitenmetallisierung einnimmt, enthält, wobei die Haftschicht eine erste Au-Schicht (1) ist und zwischen der ersten Au-Schicht (1) und der Au-Leitschicht (4) eine Diffusionsbarrierenschicht (2) liegt, **dadurch gekennzeichnet, dass** die Schichtdicke der Diffusionsbarrierenschicht (2) größer ist als die Schichtdicke der ersten Au-Schicht (1).

12. Bauteil nach Anspruch 11, **dadurch gekennzeichnet, dass** die Schichtdicke der ersten Au-Schicht (1) wenigstens 25 nm, insbesondere wenigstens 35 nm und höchstens 100 nm, insbesondere höchstens 75 nm beträgt.

13. Bauteil nach Anspruch 11 oder 12, **dadurch gekennzeichnet, dass** die Substrat-Rückseite an der Grenzfläche zu der ersten Au-Schicht (1) eine mittlere Rautiefe von weniger als 4 nm aufweist.

14. Bauteil nach Anspruch 11 bis 13, **gekennzeichnet durch** eine zwischen der Diffusionsbarrierenschicht (2) und der Au-Leitschicht (4) liegende zweite Au-Schicht (3).

15. Bauteil nach Anspruch 14, **dadurch gekennzeichnet, dass** die Diffusionsbarrierenschicht (2) zumindest im Bereich (2a) der Grenzfläche zu der ersten Au-Schicht (1) oder im Bereich (2c) der Grenzfläche zu der zweiten Au-Schicht (3) aus Ti besteht.

16. Bauteil nach einem der Ansprüche 11 bis 15, **dadurch gekennzeichnet, dass** die Diffusionsbarrierenschicht (2) zumindest in einem mittleren Schichtbereich (2b) N enthält und vorzugsweise aus TiN besteht.

17. Bauteil nach einem der Ansprüche 11 bis 16, **dadurch gekennzeichnet, dass** in dem Substrat wenigstens ein Durchgangsloch (DK) zwischen Vorderseite und Rückseite des Substrats vorhanden ist und die Rückseitenmetallisierung (RM) auch an den Wänden des wenigstens einen Durchgangslochs vorliegt.

18. Bauteil nach Anspruch 17, **dadurch gekennzeichnet, dass** die Schichtdicke zumindest der ersten Au-Schicht (1) an den Wänden des Durchgangslochs geringer ist als auf der Rückseite des Substrats.

## Claims

1. Method for producing an electronic component (EB) having at least one semiconductor component (BE) on the front side of a GaAs substrate (HS), wherein the back side of the substrate which faces away from the component is provided with a backside metallization (RM), in which a bonding layer is applied to the surface of the substrate material and then an Au conductive layer (4) having at least 50% of the overall thickness of the back-side metallization is deposited, wherein a first Au layer (1) is deposited as a bonding layer and a diffusion barrier layer (2) is deposited between the first Au layer (1) and the Au conductive layer (4), **characterized in that** the diffusion barrier layer (2) is deposited with a greater layer thickness than the first Au layer (1).

2. Method according to Claim 1, **characterized in that** the first Au layer (1) is deposited with a layer thickness of at least 25 nm, in particular at least 35 nm and at most 100 nm, in particular at most 75 nm.

3. Method according to Claim 1 or 2, **characterized in that**, before the first Au layer (1) is deposited, the back side of the substrate (HS) is polished to a mean roughness depth of less than 4 nm.

4. Method according to Claims 1 to 3, **characterized in that** a second Au layer (3) is deposited between the diffusion barrier layer (2) and the Au conductive layer (4).

5. Method according to Claim 4, **characterized in that** the diffusion barrier layer (2) consists of at least one refractory metal, in particular of Ti, at least in the region (2a) of the interface with the first Au layer and/or in the region (2c) of the interface with the second Au layer.

6. Method according to one of Claims 1 to 5, **characterized in that** the diffusion barrier layer contains N at least in a central layer region (2c).

7. Method according to one of Claims 1 to 6, **characterized in that** the first Au layer (1) and/or the diffusion barrier layer (2) and/or the second Au layer (3) are sputtered on.

8. Method according to one of Claims 1 to 7, **characterized in that** the Au conductive layer (4) is deposited galvanically.

9. Method according to one of Claims 1 to 8, **characterized in that**, before the back-side metallization (RM) is deposited, at least one passage hole (DK) through the substrate (HS) is produced, and **in that** the back-side metallization is also deposited in the passage hole.

10. Method according to Claim 9, **characterized in that** at least the first Au layer (1) is deposited with a smaller layer thickness in the passage hole (DK) than on the substrate back side.

11. Electronic component (EB) having a GaAs semiconductor substrate (HS), which has at least one semiconductor component (BE) on its substrate front side and a back-side metallization on the substrate back side, wherein the back-side metallization (RM) contains at least one bonding layer (1), which is in contact with the semiconductor material of the substrate, and an Au conductive layer, which takes up at least 50% of the layer thickness of the back-side metallization, wherein the bonding layer is a first Au layer (1) and a diffusion barrier layer (2) lies between the first Au layer (1) and the Au conductive layer (4), **characterized in that** the layer thickness of the diffusion barrier layer (2) is greater than the layer thickness of the first Au layer (1).

12. Component according to Claim 11, **characterized in that** the layer thickness of the first Au layer (1) is at least 25 nm, in particular at least 35 nm and at most 100 nm, in particular at most 75 nm.

13. Component according to Claim 11 or 12, **characterized in that** the substrate back side has a mean roughness depth of less than 4 nm at the interface with the first Au layer (1).

14. Component according to Claims 11 to 13, **characterized by** a second Au layer (3) lying between the diffusion barrier layer (2) and the Au conductive layer (4).

15. Component according to Claim 14, **characterized in that** the diffusion barrier layer (2) consists of Ti at least in the region (2a) of the interface with the first Au layer (1) or in the region (2c) of the interface with the second Au layer (3).

16. Component according to one of Claims 11 to 15, **characterized in that** the diffusion barrier layer (2) contains N and preferably consists of TiN at least in a central layer region (2b).

17. Component according to one of Claims 11 to 16, **characterized in that** at least one passage hole (DK) is present in the substrate between the front side and the back side of the substrate, and the back-side metallization (RM) is also present on the walls of the at least one passage hole.

18. Component according to Claim 17, **characterized in that** the layer thickness at least of the first Au layer (1) is smaller on the walls of the passage hole than on the back side of the substrate.

## Revendications

1. Procédé de fabrication d'un composant électronique (EB) avec au moins un élément semi-conducteur (BE) sur la face antérieure d'un substrat GaAs (HS), dans lequel la face postérieure du substrat située à l'opposé de l'élément est dotée d'une métallisation de la face postérieure (RM), dans laquelle une couche d'accrochage est déposée sur la surface du matériau du substrat et ensuite une couche conductrice d'or (4) est déposée avec une épaisseur d'au moins 50 % de l'épaisseur totale de la métallisation de la face postérieure, dans lequel on dépose comme couche d'accrochage une première couche d'or (1) et on dépose une couche de barrière de diffusion (2) entre la première couche d'or (1) et la couche conductrice d'or (4), **caractérisé en ce que** l'on dépose la couche de barrière de diffusion (2) avec une plus grande épaisseur de couche que la première couche d'or (1).

2. Procédé selon la revendication 1, **caractérisé en ce que** l'on dépose la première couche d'or (1) avec une épaisseur de couche d'au moins 25 nm, en particulier d'au moins 35 nm et au plus de 100 nm, en particulier au plus de 75 nm.

3. Procédé selon la revendication 1 ou 2, **caractérisé en ce que**, avant le dépôt de la première couche d'or (1), on polit la face postérieure du substrat (HS) jusqu'à une profondeur de rugosité moyenne de moins de 4 nm.

4. Procédé selon une revendication 1 à 3, **caractérisé en ce que** l'on dépose une deuxième couche d'or (3) entre la couche de barrière de diffusion (2) et la couche conductrice d'or (4).

5. Procédé selon la revendication 4, **caractérisé en ce que** la couche de barrière de diffusion (2) se compose, au moins dans la région (2a) de la surface limite vers la première couche d'or et/ou dans la région (2c) de la surface limite vers la deuxième couche d'or, d'au moins un métal réfractaire, en particulier de Ti.

6. Procédé selon l'une quelconque des revendications 1 à 5, **caractérisé en ce que** la couche de barrière de diffusion contient de l'azote N au moins dans une zone centrale (2c) de la couche.

7. Procédé selon l'une quelconque des revendications 1 à 6, **caractérisé en ce que** l'on dépose la première couche d'or (1) et/ou la couche de barrière de diffusion (2) et/ou la deuxième couche d'or (3) par pulvérisation cathodique.

8. Procédé selon l'une quelconque des revendications 1 à 7, **caractérisé en ce que** l'on dépose la couche conductrice d'or (4) par voie galvanique.

9. Procédé selon l'une quelconque des revendications 1 à 8, **caractérisé en ce que**, avant le dépôt de la métallisation de la face postérieure (RM), on produit au moins un trou passant (DK) à travers le substrat (HS) et **en ce que** l'on dépose la métallisation de la face postérieure également dans le trou passant.

10. Procédé selon la revendication 9, **caractérisé en ce que** l'on dépose au moins la première couche d'or (1) dans le trou passant (DK) avec une épaisseur de couche plus faible que sur la face postérieure du substrat.

11. Composant électronique (EB) avec un substrat semi-conducteur GaAs (HS), qui présente au moins un élément semi-conducteur (BE) sur sa face antérieure de substrat et une métallisation de la face postérieure sur la face postérieure du substrat, dans lequel la métallisation de la face postérieure (RM) comprend au moins une couche d'accrochage (1) se trouvant en contact avec le matériau semi-conducteur du substrat et une couche conductrice d'or, qui occupe au moins 50 % de l'épaisseur de couche de la métallisation de la face postérieure, dans lequel la couche d'accrochage est une première couche d'or (1) et il se trouve une couche de barrière de diffusion (2) entre la première couche d'or (1) et la couche conductrice d'or (4), **caractérisé en ce que** l'épaisseur de couche de la couche de barrière de diffusion (2) est plus grande que l'épaisseur de couche de la première couche d'or (1).

12. Composant selon la revendication 11, **caractérisé en ce que** l'épaisseur de couche de la première couche d'or (1) vaut au moins 25 nm, en particulier au moins 35 nm, et au plus 100 nm, en particulier au plus 75 nm.

13. Composant selon la revendication 11 ou 12, **caractérisé en ce que** la face postérieure du substrat présente, à la surface limite vers la première couche d'or (1), une profondeur de rugosité moyenne de moins de 4 nm.

14. Composant selon une revendication 11 à 13, **caractérisé par** une deuxième couche d'or (3) située entre la couche de barrière de diffusion (2) et la couche conductrice d'or (4).

15. Composant selon la revendication 14, **caractérisé en ce que** la couche de barrière de diffusion (2) se compose de Ti au moins dans la région (2a) de la surface limite vers la première couche d'or (1) et/ou dans la région (2c) de la surface limite vers la deuxième couche d'or (3).

16. Composant selon l'une quelconque des revendications 11 à 15, **caractérisé en ce que** la couche de barrière de diffusion (2) contient du N et se compose de préférence de TiN au moins dans une zone centrale (2b) de la couche.

17. Composant selon l'une quelconque des revendications 11 à 16, **caractérisé en ce qu'**il se trouve dans le substrat au moins un trou passant (DK) entre la face antérieure et la face postérieure du substrat et la métallisation de la face postérieure (RM) est également présente sur les parois dudit au moins un trou passant.

18. Composant selon la revendication 17, **caractérisé en ce que** l'épaisseur de couche au moins de la première couche d'or (1) sur les parois du trou passant est plus faible que sur la face postérieure du substrat.
